# EUROPEAN PATENT SPECIFICATION

(11) **EP 2 149 538 B1**
(45) Date of publication and mention of the grant of the patent: **06.03.2019**
(21) Application number: 09166394.8
(22) Date of filing: 24.07.2009
(51) Int. Cl.: C01B 32/16, C01B 32/168, F28F 13/00, F28F 21/02, H01L 23/373, H01L 21/48

(54) **Interface-infused nanotube interconnect**
Schnittstelleneingeleitete Nanorohrverbindung
Interconnexion de nanotubes au moyen d'une interface

(30) Priority: 25.07.2008 US 180106
(43) Date of publication of application: 03.02.2010
(73) Proprietor: Lockheed Martin Corporation, Bethesda, MD 20817 (US)
(72) Inventor: Slinker, Keith A., Keller, TX 76248 (US); Poenitzsch, Vasiliki Z., Alamo Heights, TX 78209 (US)
(74) Representative: Sessford, Russell

(56) References cited:
- WO-A2-2007/124477
- WO-A2-2007/126412
- US-A1- 2004 266 065
- US-A1- 2007 244 245
- US-A1- 2008 075 954
- US-A1- 2008 128 122
- PANZER M A ET AL: "Thermal properties of metal-coated vertically aligned single-wall nanotube arrays" JOURNAL OF HEAT TRANSFER ASME USA, vol. 130, no. 5, May 2008 (2008-05), pages 052401-1, XP008128346 ISSN: 0022-1481
- KINOSHITA ET AL: "Synthesis and mechanical properties of carbon nanotube/diamond-like carbon composite films" DIAMOND AND RELATED MATERIALS, ELSEVIER SCIENCE PUBLISHERS, AMSTERDAM, NL, vol. 16, no. 11, 18 October 2007 (2007-10-18), pages 1940-1944, XP022303888 ISSN: 0925-9635
- YANG YAODONG, ET AL.: "Electrophoresis coating of titanium dioxide on aligned carbon nanotubes for controlled syntheses of photoelectronic nanomaterials" ADVANCED MATERIALS, vol. 19, 5 April 2007 (2007-04-05), pages 1239-1243, XP002607442
- CI L ET AL: "Investigation of the interfacial reaction between multi-walled carbon nanotubes and aluminum" ACTA MATERIALIA, ELSEVIER, OXFORD, GB LNKD- DOI:10.1016/J.ACTAMAT.2006.06.031, vol. 54, no. 20, 1 December 2006 (2006-12-01), pages 5367-5375, XP025027747 ISSN: 1359-6454 [retrieved on 2006-12-01]
- AHN H J ET AL: "Co(OH)2-combined carbon-nanotube array electrodes for high-performance micro-electrochemical capacitors" ELECTROCHEMISTRY COMMUNICATION, ELSEVIER, AMSTERDAM, NL LNKD- DOI:10.1016/J.ELECOM.2008.06.018, vol. 10, no. 9, 28 June 2008 (2008-06-28), pages 1284-1287, XP024098972 ISSN: 1388-2481 [retrieved on 2008-06-28]
- CAMACHO R E ET AL: "Carbon nanotube arrays for photovoltaic applications" JOM MARCH 2007 MINERALS, METALS AND MATERIALS SOCIETY US, vol. 59, no. 3, March 2007 (2007-03), pages 39-42, XP002607443 DOI: DOI:10.1007/S11837-007-0037-0
- GARCIA E J ET AL: "Fabrication of composite microstructures by capillary-driven wetting of aligned carbon nanotubes with polymers" NANOTECHNOLOGY, IOP, BRISTOL, GB LNKD- DOI:10.1088/0957-4484, vol. 18, 1 January 2007 (2007-01-01), pages 1-11, XP009108917 ISSN: 0957-4484
- ELIJAH B SANSOM ET AL: "Controlled partial embedding of carbon nanotubes within flexible transparent layers" NANOTECHNOLOGY, IOP, BRISTOL, GB, vol. 19, no. 3, 23 January 2008 (2008-01-23), page 35302, XP020129682 ISSN: 0957-4484

## Description

### Field of the Invention

The present invention relates to a method of fabricating arrays of carbon nanotubes and carbon nanotube arrays.

### Background of the Invention

Carbon nanotubes (CNTs) have gained much interest due to the very unique and desirable properties exhibited by the materials and by devices that are prepared with CNTs. Carbon nanotubes are very small tube-shaped structures each having the structure of a graphite sheet rolled into a tube. Carbon nanotubes exhibit excellent mechanical properties, such as for example, a high Young's modulus, a high elastic modulus, and low density. In addition, CNTs also demonstrate excellent electrical, thermal, electromechanical and absorption properties. Carbon nanotubes display electronic metallic properties or semiconductor properties according to different ways in which the graphite sheet is rolled. Due to these and other properties, it has been suggested that carbon nanotubes may play an important role in a variety of different fields, for example, microscopic electronics, materials science, biology and chemistry. One particular use that has been suggested is as a field emission cathodes for the replacement of thermionic cathodes used in microwave tubes.

Carbon nanotubes are also highly desirable due to their ability to form self-assembling linear, forest-like arrays. CNT arrays have been shown to have high thermal and electrical conductivity, extremely low optical reflectivity, excellent emission properties, and to be compliant yet strong. Thus they have been suggested for applications such as field emission devices, conformable electrical interconnects, and mechanically resilient thermal interconnects. However, these CNT arrays generally show poor adhesion and poor conductivity to the substrates they are synthesized on as well as low self-integrity, thereby limiting their potential for use in forming matrices and the fabrication of microelectronic and other devices.

WO2007/126412 discloses arrays of longitudinally aligned carbon nanotubes having specified positions, nanotube densities, and orientations, and corresponding methods of making carbon nanotube arrays using guided growth and guided deposition methods.

US2008128122 discloses a thermal interface material which includes a matrix, a plurality of carbon nanotubes, and at least one phase change layer. The matrix includes a first surface and an opposite second surface. The carbon nanotubes are embedded in the matrix uniformly. The carbon nanotubes extend from the first surface to the second surface and have two opposite ends. At least one of the two opposite ends of the carbon nanotubes is exposed out of one of the first and second surfaces of the matrix. The at least one phase change layer is formed on the exposed end of the carbon nanotubes.

US2007244245 discloses a carbon nanotube composite material including a matrix material having two opposite surfaces, a number of CNTs each having two opposite end portions embedded in the matrix material. The two opposite end portions of each CNT extend to and, potentially, out of the respective two opposite surfaces of the matrix material. A method for manufacturing the carbon nanotube composite material is also disclosed which includes the steps of: providing a substrate and forming a carbon nanotube array in a selective pattern thereon; providing a pair of protective layers, a respective protective layer being attached on a corresponding portion of ends of CNTs; filling clearances existing among CNTs and between the two protective layers with a matrix material; and removing the protective layers from CNTs.

### Summary

An aspect of the present invention provides a method of forming a carbon nanotube array, comprising: providing a substrate suitable for supporting the growth of a plurality of carbon nanotubes; depositing a vertically aligned layer of carbon nanotubes on a surface of the substrate, said carbon nanotubes having a first end and a second end, wherein the first end is attached to the substrate and wherein said plurality of carbon nanotubes forms a forest of aligned nanotubes; depositing a first coating on the second end of the carbon nanotubes that becomes infused into the layer of carbon nanotubes, wherein: (i) the first coating is silicon carbide and the depositing is by chemical vapor deposition or (ii) the first coating is a poly(methylsilyne) applied as solution and then pyrolyzed to achieve a silicon carbide coating; removing the substrate from the first end of the carbon nanotubes; and depositing a second coating on the first end of the carbon nanotubes that becomes infused into the layer of carbon nanotubes, wherein: (i) the second coating is silicon carbide and the depositing is by chemical vapor deposition or (ii) the second coating is a poly(methylsilyne) applied as solution and then pyrolyzed to achieve a silicon carbide coating.

Another aspect of the present invention provides a carbon nanotube array, comprising: a plurality of vertically aligned carbon nanotubes, said nanotubes having a first and a second end; and a first coating coupled to the second end of the plurality of vertically aligned carbon nanotubes, wherein the first coating infuses into the plurality of vertically aligned carbon nanotubes and the first coating is silicon carbide; and a second coating coupled to the first end of the plurality of vertically aligned carbon nanotubes, wherein the second coating infuses into the plurality of vertically aligned carbon nanotubes and the second coating is silicon carbide.

In one described arrangement, a method is provided for the preparation of vertically aligned carbon nanotube arrays that incorporate a coating on at least one end of the array. A substrate suitable for supporting the growth of carbon nanotubes is provided and a plurality of carbon nanotubes are synthesized on a surface of the substrate. The carbon nanotubes include a first end and a second end, wherein the first end is attached to the substrate and wherein said plurality of carbon nanotubes forms a forest of substantially vertically aligned nanotubes. A coating is then deposited on the second end of the carbon nanotubes.

In certain described arrangement, the method further includes the steps of removing the substrate from the first end of the carbon nanotubes and depositing a second coating on the first end of the carbon nanotubes. The coating layer can be selected from a variety of materials, including metal, composites, alloys, and polymers.

In another described arrangement, a carbon nanotube array is provided that incorporates a coating on at least one end of the carbon nanotube array, wherein the coating is partially infused into the carbon nanotube array. Aspects of the present invention are recited by the appended claims.

### Brief Description of the Drawings

Figure 1 is a schematic of the process for the preparation of carbon nanotube arrays according to one described arrangement.
Figure 2 is a scanning electron micrograph of a carbon nanotube array.
Figure 3 is a carbon nanotube device according to one described arrangement.
Figure 4 is a carbon nanotube device according to another described arrangement.
Figure 5 is a carbon nanotube device according to another described arrangement.
Figure 6 is a carbon nanotube device according to another described arrangement.
Figure 7 is a carbon nanotube device according to another described arrangement.
Figure 8 is a carbon nanotube device according to another described arrangement.
Figure 9 is a scanning electron micrograph of various coating layers on a CNT array according to one described arrangement.
Figure 10 is a scanning electron micrograph of a CNT device according to a described arrangement.

### Detailed description

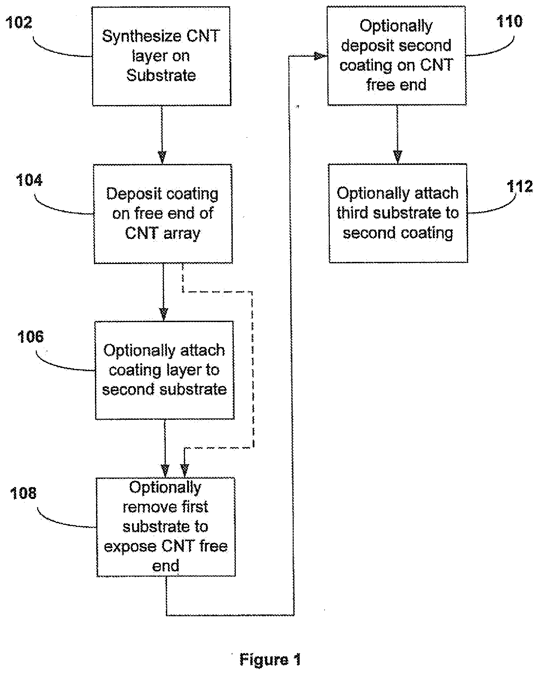

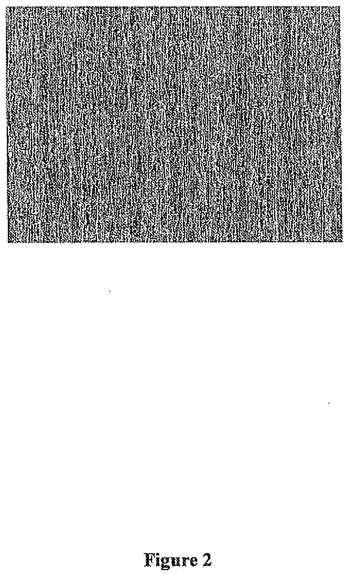

In one described arrangement, a method is provided for the preparation of a CNT array that includes a coating on at least one end of the array. The process for preparing arrays according to one described arrangement is shown in the schematic in Figure 1. In a first step 102, a substantially vertically aligned CNT layer is deposited on the surface of a substrate. An exemplary scanning electron micrograph of a CNT array is shown in Figure 2. In a second step 104, a coating is applied to the exposed end of the CNT layer. The coating in described arrangements can be metal, diamond-like carbon (DLC), polymer, silicon carbide or the like and becomes partially imbedded or infused into the CNT layer. In an optional third step 106, the coating layer is attached to a second substrate. In an optional fourth step 108, following either step 104 or 106, the first substrate can be removed to expose a free end of the CNT layer. In an optional fifth step 110, a second coating layer can be deposited on the newly exposed free end of the CNT layer in a manner similar to the deposition of the first layer. In an optional sixth step 112, the second coating layer can be attached to a third substrate. As described, the first and second coating layers can be the same, or they can be different. Similarly, the first, second and third substrates can be the same material or they can be different.

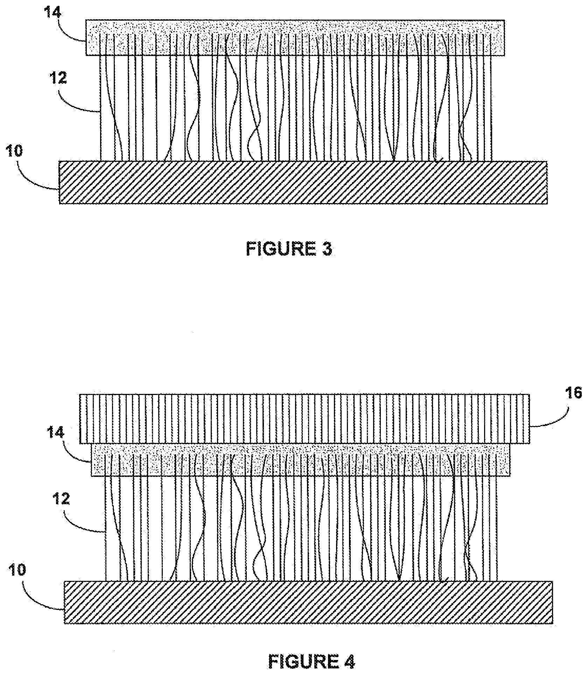

In one described arrangement, as shown in Figure 3, the CNT array can include a substrate material 10, a substantially vertically aligned CNT layer 12 and a coating 14 that partially infuses into the CNT layer to provide a cap to the free end of the CNT layer distal from the substrate surface. The CNT layer 12 is attached to the substrate 10 at a first end, and the coating 14 is applied to a second end of the CNT layer.

The substrate 10 material can be a variety of known material suitable for the growth of CNTs. One exemplary substrate material is silicon dioxide (or a silicon substrate that has been oxidized), which provides the advantage of having a surface from which the CNT layer may be easily removed.

The carbon nanotubes 12 can be applied to the substrate 10 by known means, including but not limited to, chemical vapor deposition (CVD) synthesis or plasma enhanced chemical vapor deposition (PECVD), such as the Black Magic process (Slade Gardner, et al.). The chemical vapor deposition method is known in the art as being conducive to growing CNT arrays with the nanotubes that are substantially aligned and form a forest-like growth that is oriented substantially vertical to the surface of the substrate. In the chemical vapor deposition method, a carbon source gas is thermally decomposed at a predetermined temperature in the presence of a transition metal that acts as a catalyst, thereby forming a carbon nanotube array. In certain described arrangements, the substrate may be prepared or conditioned by known means prior to the deposition of the CNTs to promote the growth and/or attachment on the surface thereof. In certain described arrangements, the carbon nanotubes deposit in a manner such that the nanotubes only occupy about 10% of the total volume. In certain other described arrangements, the carbon nanotubes occupy between about 10% of the total volume and about 20% of the total volume. In certain described arrangements, with post processing techniques, the CNTs can occupy greater than about 50% of the total volume, greater than 75% of the volume, and in certain described arrangements, greater than 90% of the total volume.

In certain described arrangements, the CNT layer can be between about 1 micron and several centimeters in length. In certain other described arrangements, the CNT layer can be between about 1 micron and 100 microns. In certain described arrangements, the CNT layer can be between about 2 microns and 20 microns. It is understood that as the technology advances, CNT arrays of lengths longer than several centimeters will be possible.

The coating or cap layer 14 can be a metal, ceramic, composite, alloy, or polymer material that partially infuses into the CNT layer. The coating or cap layer 14 can be applied to the free ends of the CNT layer 12 by a variety of means. In certain described arrangements, the material can be applied by vapor phase deposition, including, for example, chemical vapor deposition (CVD) PECVD, or physical vapor deposition. A variety of materials can be applied to the carbon nanotubes by these techniques, particularly metals, such as for example, but not limited to, titanium, aluminum, molybdenum, tungsten, tantalum, nickel, gold, silver, copper, and the like. In certain described arrangements, alloys and compounds typically used in the microelectronics industry, including but not limited to, silicon dioxide, silicon-germanium, silicon nitride, silicon oxynitride and titanium nitride, can be applied by vapor phase deposition. In certain described arrangements, diamond-like carbon or diamond-like nanocomposite coatings (such as for example, composites that include carbon, hydrogen, silicon and oxygen) can be applied to the ends of the carbon nanotubes by known methods. In certain other described arrangements, the metals can be deposited on the surface by magnetron sputter deposition. The process conditions for the vapor phase deposition, such as temperature and power, can be varied to change or modify the resulting coating.

In certain described arrangements, silicon carbide can be deposited on the surface of the CNT array by CVD techniques. Alternatively, a poly(methylsilyne) can be applied to the CNT surface as a solution and pyrolyzed to achieve the silicon carbide coating.

In certain described arrangements, the coating can be applied to the exposed carbon nanotube end by depositing the material as a liquid. Materials suitable for liquid deposition include, but are not limited to, aluminum, solder (e.g., Pb-Sn), and silicon carbide precursors, in addition to a variety of organic and organometallic polymers. Penetration of the liquid can be controlled by a variety of means, including but not limited to, the amount of time the surface is exposed to the liquid, the viscosity of the liquid, the hydrophobicity of the liquid and the conditions under which the liquid is applied to the CNT layer (i.e., the layer is heated, the liquid is heated, etc). In certain described arrangementswherein a polymer is used to infuse the carbon nanotube array, the array may undergo a cure of post deposition process, depending on the polymer used.

The coating infuses or imbeds itself into the carbon nanotube array. In certain described arrangements, the coating infuses between about 1 and 3 microns into the carbon nanotube array. In other embodiments, the coating infuses between about 2 and 6 microns. In yet other described arrangements, the coating can infuse the carbon nanotubes by up to about 10 microns. In yet other described arrangements, the coating can penetrate further into the array, up to and including the entire carbon nanotube array to the substrate.

The coating material can be selected based upon the desired properties and end application. In certain described arrangements, the coating material, whether applied by vapor phase or liquid deposition, is selected such that the coefficient of thermal expansion (CTE) closely matches that of the substrate to which it is to be attached. Alternatively, in another described arrangement, the coating material is selected such that the CTE of the coating material closely matches that of the CNT layer. In yet another described arrangements, the coating material is selected to achieve maximum thermal conductivity. In yet another described arrangements, the coating material is selected for maximum mechanical stability. In yet another described arrangements, the coating material is selected to achieve maximum electrical conductivity. In yet another described arrangements, the coating material is selected for its optical behavior. In yet another described arrangements, the coating material is selected to maximize adhesion to the substrate to which is will be attached. In yet another described arrangements, the coating material can include more than one material. In described arrangements wherein the CNT array is positioned between two coating layers, the coatings can be the same, or in alternate described arrangements, the coatings can be different. In yet other described arrangements, a coating may include more than one material.

In another described arrangements, the coating layer on the CNT array can provide additional means from which to manipulate the CNT array. The metal layer provides mechanical strength and electrical conductivity to the system. In certain described arrangements, the metal layer can be attached to a second substrate material, as shown for example, in Figure 4, wherein the metal coating 14 is attached or adhered to a second substrate 16. Exemplary materials to adhere the metal coating 14 to a second substrate 16 include known adhesives (including but not limited to pressure adhesives and tapes), epoxies and other heat or chemically activated adhesives and solders, as is known in the art. Preferably, the means for attaching the second substrate are selected based upon the end use of the array.

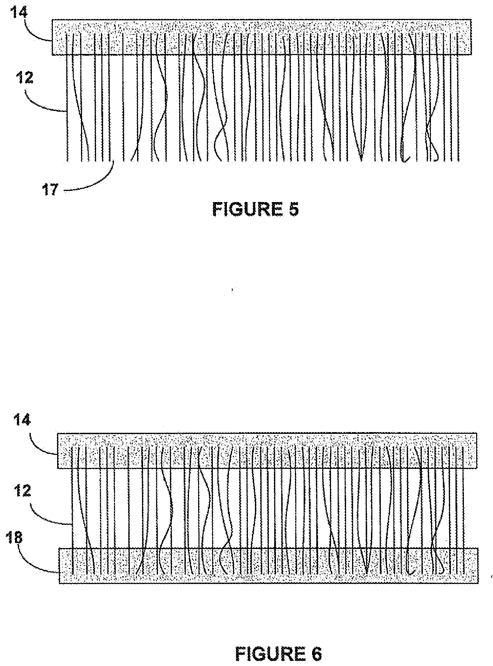

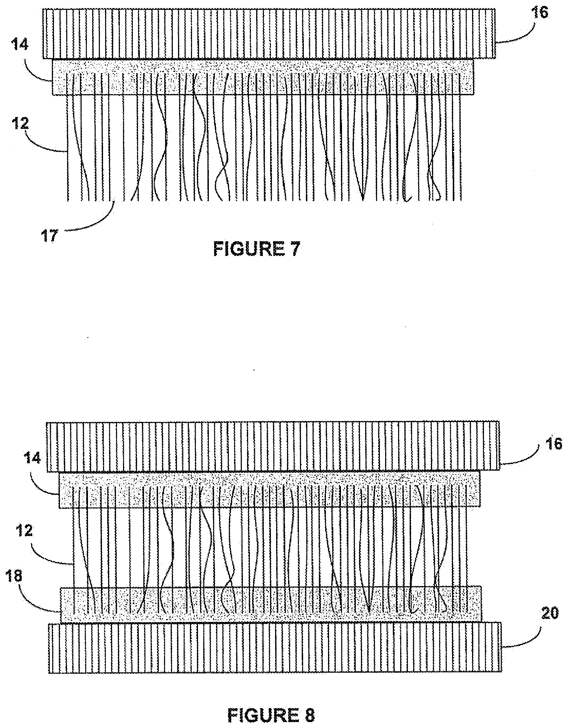

In certain described arrangements, as shown in Figures 5 and 7, the initial substrate 10 can be removed from the array to expose the first end 17 of the CNT layer 12, thereby allowing the CNT layer to be manipulated. The coated CNT layered structure can typically be easily removed from the substrate on which the CNTs are initially grown. Generally, the adhesion of the CNT layer to the substrate is poor, thereby facilitating removal. In certain described arrangements, only a small amount of effort may be all that is required to peel off the coated CNT layer from the substrate. As noted previously, in certain described arrangements, the CNT array can be prepared on a silicon substrate, which thereby facilitates the removal of the carbon nanotubes from the substrate surface. In certain described arrangements, heat may be applied to the CNT array to facilitate the removal of the array from the substrate. In certain described arrangements, the CNT array may be heated to about 500 C in air to promote removal of the CNT and coating layer from the growth substrate. In certain other described arrangements, a chemical release agent can be applied to the CNT and coating layer to facilitate removal of the carbon nanotube array from the substrate.

As shown in Figure 6, a second coating layer 18 can be applied to the newly exposed CNT layer 12 according to the deposition means previously described. The second coating 18 can be the same material as was applied as the first coating 14, or it can be a different material. The resulting structure can have a sandwich-like structure (e.g. metal-CNT layer-metal or metal-CNT layer -ceramic).

As shown in Figure 8, the second coating 18 can be attached or adhered to a third substrate 20 by the means previously described with respect to the attachment of second substrate 16 to the first coating layer 14.

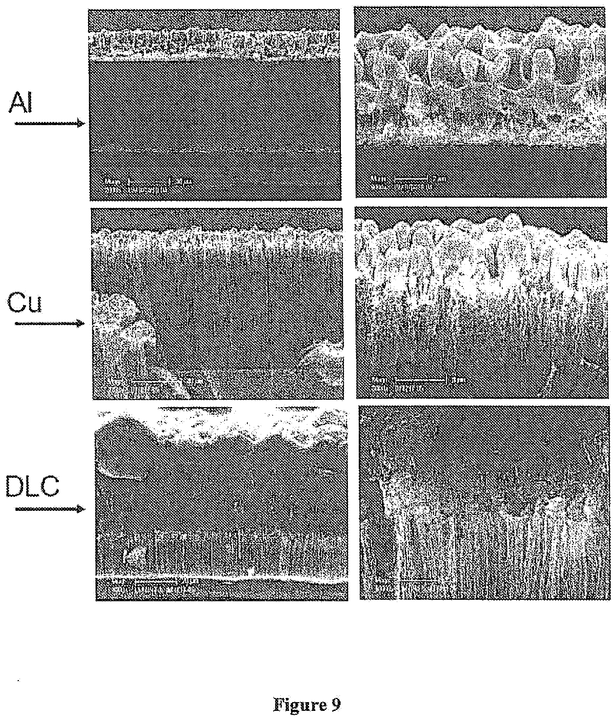

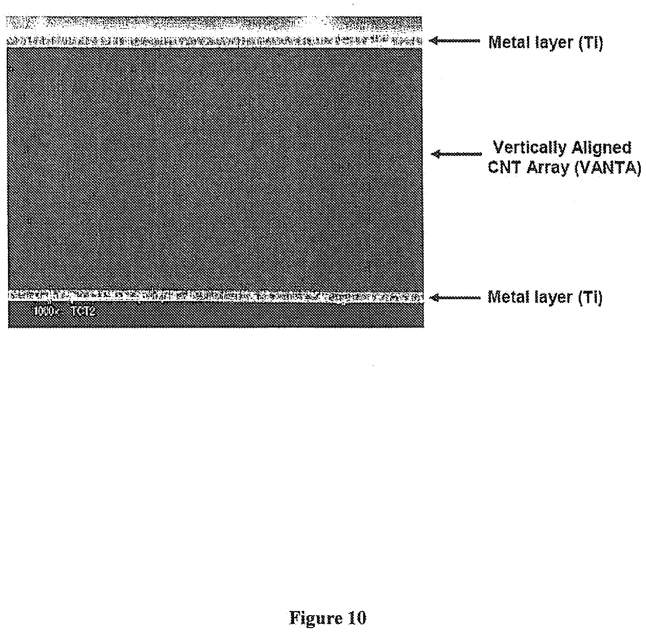

Figure 9 shows a scanning electron micrograph from a scanning electron microscope (SEM) of an exemplary CNT array wherein a vertically aligned CNT array is positioned between titanium coatings. Figure 10 shows scanning electron micrographs for the deposition of aluminum, copper and diamond-like carbon (DLC) onto one surface of a CNT array.

In certain described arrangements, one or both of the surfaces of the CNT layer can be modified by chemical or physical means prior to the deposition of the coating layer. In certain described arrangements, the surface of the CNT layer can be exposed to a plasma source prior to deposition of the coating layer.

Characterization of the coated structure demonstrates that the CNTs of the coated CNT arrays are not affected by the coating process as Raman spectroscopy reveals that the materials are the same, before and after the application of the coating layer.

In certain described arrangements, the tensile strength of the metal-CNT layer interface is at least about 5 MPa. In certain other described arrangements, the tensile strength is at least about 7 MPa. In yet other described arrangements, the tensile strength is at least about 8 MPa. In yet other described arrangements, the tensile strength is greater than at least about 10 MPa.

Individual single carbon nanotubes have high tensile strength and high thermal conductivity along their axis. The typical CNT array is characterized in that it is compressible such that it is both structurally and mechanically similar to an open-celled foam structure. The typical CNT arrays prepared according to the methods provided herein have a conductivity of at least about 10 W/mK, preferably at least about 15 W/mK.

In certain described arrangements, a thick coating can be applied to the CNT array to provide a system that is self supporting. In certain described arrangementswherein coating is a metal layer about 5 microns thick. In certain other described arrangements, the metal coating layer can be about 4 microns thick. In yet other described arrangements, the metal layer is between about 4 and 7 microns thick. As is understood in the art, the thickness of the coating layer required for the array to be self supporting varies based upon the particular coating material and the parameters under which it is deposited.

Infusion of the coating into the top region or top few microns of the carbon nanotube array can lead to improved adhesion and higher conductivity of the coating to the carbon nanotube array as compared with a coating that is not infused into the CNT array. By limiting the infusion of the coating to the top region or top few microns of the CNT array, the bulk properties of the carbon nanotube array, such as for example, compliancy, can be preserved. The amount of infusion can be controlled through choice of such parameters as coating material, method of deposition, and deposition parameters.

Controlling the coating thickness and the amount of infusion of the coating into the CNT array are aspects of the invention which allows for the manipulation of the coated CNT arrays, and may have additional applications outside of the primary focus of this disclosure. For example, the CNT array has been characterized elsewhere to have excellent optical absorbance (e.g. it is very black). The coated CNT array can be applied to an object such that the foil side is applied or adhered to the surface of the object, such that the uncoated side of the CNT array were exposed, thereby providing an alternative to painting an object black.

The CNT array can also be used as a thermal interconnect, wherein a first object can be attached to the coated face of the CNT array (e.g. by soldering or with epoxy or any other known adhesive) and the second object can be attached or adhered to the opposite face of the CNT array. In this device, there is no mechanical connection between the CNT array and the surface of the second object, however the thermal conductivity though the CNT array would still be high. Thermal conduction may be decreased if the system experiences mechanical stress.

Exemplary devices that can be prepared from the carbon nanotube devices described herein include devices suitable for the removal of heat from an electronic device. The carbon nanotube array can be connected to a cold plate or thermal spreader at one end, thereby facilitating the transfer of heat through the carbon nanotube array.

The singular forms "a", "an" and "the" include plural referents, unless the context clearly dictates otherwise.

Optional or optionally means that the subsequently described event or circumstances may or may not occur. The description includes instances where the event or circumstance occurs and instances where it does not occur.

Ranges may be expressed herein as from about one particular value, and/or to about another particular value. When such a range is expressed, it is to be understood that another embodiment is from the one particular value and/or to the other particular value, along with all combinations within said range.

## Claims

1. A method of forming a carbon nanotube array, comprising:
providing a substrate suitable for supporting the growth of a plurality of carbon nanotubes;
depositing a vertically aligned layer of carbon nanotubes on a surface of the substrate, said carbon nanotubes having a first end and a second end, wherein the first end is attached to the substrate and wherein said plurality of carbon nanotubes forms a forest of aligned nanotubes;
depositing a first coating on the second end of the carbon nanotubes that becomes infused into the layer of carbon nanotubes, wherein: (i) the first coating is silicon carbide and the depositing is by chemical vapor deposition or (ii) the first coating is a poly(methylsilyne) applied as solution and then pyrolyzed to achieve a silicon carbide coating;
removing the substrate from the first end of the carbon nanotubes; and
depositing a second coating on the first end of the carbon nanotubes that becomes infused into the layer of carbon nanotubes, wherein: (i) the second coating is silicon carbide and the depositing is by chemical vapor deposition or (ii) the second coating is a poly(methylsilyne) applied as solution and then pyrolyzed to achieve a silicon carbide coating.

2. A carbon nanotube array, comprising:
a plurality of vertically aligned carbon nanotubes, said nanotubes having a first and a second end; and
a first coating coupled to the second end of the plurality of vertically aligned carbon nanotubes, wherein the first coating infuses into the plurality of vertically aligned carbon nanotubes and the first coating is silicon carbide; and
a second coating coupled to the first end of the plurality of vertically aligned carbon nanotubes, wherein the second coating infuses into the plurality of vertically aligned carbon nanotubes and the second coating is silicon carbide.

## Patentansprüche

1. Verfahren zur Herstellung einer Kohlenstoffnanorohr-Anordnung, umfassend:
Bereitstellen eines Substrats, das dazu geeignet ist, das Wachstum einer Mehrzahl von Kohlenstoffnanorohren zu unterstützen;
Abscheiden einer vertikal ausgerichteten Schicht von Kohlenstoffnanorohren auf einer Oberfläche des Substrats, wobei die Kohlenstoffnanorohre ein erstes Ende und ein zweites Ende aufweisen, worin das erste Ende an das Substrat angelagert ist und worin die Mehrzahl von Kohlenstoffnanorohren einen Wald von ausgerichteten Nanorohren bildet;
Abscheiden einer ersten Beschichtung auf dem zweiten Ende der Kohlenstoffnanorohre, die in die Schicht der Kohlenstoffnanorohre eingeleitet wird, worin: (i) die erste Beschichtung Siliziumkarbid ist und das Abscheiden durch chemische Dampfabscheidung erfolgt oder (ii) die erste Beschichtung ein Poly(methylsilyn) ist, das als Lösung angewendet und dann pyrolysiert wird, um eine Siliziumkarbidbeschichtung zu erzielen;
Entfernen des Substrats von dem ersten Ende der Kohlenstoffnanorohre; und
Abscheiden einer zweiten Beschichtung auf dem ersten Ende der Kohlenstoffnanorohre, die in die Schicht der Kohlenstoffnanorohre eingeleitet wird, worin: (i) die zweite Beschichtung Siliziumkarbid ist und das Abscheiden durch chemische Dampfabscheidung erfolgt oder (ii) die zweite Beschichtung ein Poly(methylsilyn) ist, das als Lösung angewendet und dann pyrolysiert wird, um eine Siliziumkarbidbeschichtung zu erzielen.

2. Kohlenstoffnanorohr-Anordnung, umfassend:
eine Mehrzahl von vertikal ausgerichteten Kohlenstoffnanorohren, wobei die Nanorohre ein erstes Ende und ein zweites Ende aufweisen; und
eine erste Beschichtung, die an das zweite Ende der Mehrzahl der vertikal ausgerichteten Kohlenstoffnanorohre gekoppelt ist, worin die erste Beschichtung in die Mehrzahl der vertikal ausgerichteten Kohlenstoffnanorohre eingeleitet wird und die erste Beschichtung Siliziumkarbid ist; und
eine zweite Beschichtung, die an das erste Ende der Mehrzahl der vertikal ausgerichteten Kohlenstoffnanorohre gekoppelt ist, worin die zweite Beschichtung in die Mehrzahl der vertikal ausgerichteten Kohlenstoffnanorohre eingeleitet wird und die zweite Beschichtung Siliziumkarbid ist.

## Revendications

1. Procédé destiné à former un réseau de nanotubes de carbone, consistant à :
fournir un substrat convenant pour favoriser la croissance d'une pluralité de nanotubes de carbone ;
déposer une couche de nanotubes de carbone alignés verticalement sur une surface du substrat, lesdits nanotubes de carbone ayant une première extrémité et une deuxième extrémité, dans lequel la première extrémité est assujettie au substrat et dans lequel ladite pluralité de nanotubes de carbone forme une forêt de nanotubes alignés ;
déposer un premier revêtement sur la deuxième extrémité des nanotubes de carbone lequel s'imprègne dans la couche de nanotubes de carbone, dans lequel : (i) le premier revêtement est du carbure de silicium et le dépôt est effectué par déposition de vapeur chimique ou (ii) le premier revêtement est du poly(méthylsilyne) appliqué sous forme de solution, puis pyrolysé pour réaliser un revêtement de carbure de silicium ;
retirer le substrat de la première extrémité des nanotubes de carbone ; et
déposer un deuxième revêtement sur la première extrémité des nanotubes de carbone lequel s'imprègne dans la couche de nanotubes de carbone, dans lequel : (i) le deuxième revêtement est du carbure de silicium et le dépôt est effectué par déposition de vapeur chimique ou (ii) le deuxième revêtement est du poly(méthylsilyne) appliqué sous forme de solution, puis pyrolysé pour réaliser un revêtement de carbure de silicium.

2. Réseau de nanotubes de carbone, comprenant :
une pluralité de nanotubes de carbone alignés verticalement, lesdits nanotubes ayant une première et une deuxième extrémités ; et
un premier revêtement couplé à la deuxième extrémité de la pluralité de nanotubes de carbone alignés verticalement, dans lequel le premier revêtement s'imprègne dans la pluralité de nanotubes de carbone alignés verticalement et le premier revêtement est du carbure de silicium ; et
un deuxième revêtement couplé à la première extrémité de la pluralité de nanotubes de carbone alignés verticalement, dans lequel le deuxième revêtement s'imprègne dans la pluralité de nanotubes de carbone alignés verticalement et le deuxième revêtement est du carbure de silicium.
